# EUROPEAN PATENT SPECIFICATION

(11) **EP 2 245 683 B1**
(45) Date of publication and mention of the grant of the patent: **28.08.2019**
(21) Application number: 09713125.4
(22) Date of filing: 20.01.2009
(51) Int. Cl.: H01L 51/54

(54) **ORGANIC LIGHT EMITTING DEVICE AND METHOD FOR MANUFACTURING THE SAME**
ORGANISCHES LICHT EMITTIERDE VORRICHTUNG UND VERFAHREN ZU IHRER HERSTELLUNG
DISPOSITIF ÉLECTROLUMINESCENT ORGANIQUE ET SON PROCÉDÉ DE FABRICATION

(30) Priority: 19.02.2008 US 33033
(43) Date of publication of application: 03.11.2010
(73) Proprietor: BOE Technology Group Co., Ltd., Chaoyang District Beijing (CN)
(72) Inventor: LIU, Jie, Niskayuna, NY 12309 (US); YE, Qing, Schenectady, NY 12309 (US); LIANG, Yangang, Shanghai 201208 (CN); LIU, Shengxia, Shanghai 200123 (CN)
(74) Representative: Klunker IP Patentanwälte PartG mbB
(86) International application number: PCT/US2009/031443
(87) International publication number: WO 2009/105301

(56) References cited:
- JP-A- 2006 019 156
- US-A1- 2005 147 842
- TANAKA, D., AGATA, Y., TAKEDA, T., WATANABE, S., AND KIDO, J.: "High Luminous Efficiency Blue Organic Light-Emitting Devices Using High Triplet Excited Energy Materials" JAPANESE JOURNAL OF APPLIED PHYSICS, vol. 46, no. 5, 26 January 2007 (2007-01-26), pages L117-L119, XP002523000
- KIDO, J.: "Recent Progress in Organic Light-Emitting Devices" IEEE POLYTRONIC 2007 CONFERENCE, 2007, pages 18-19, XP002523001
- Abhishek P. Kulkarni ET AL: "Electron Transport Materials for Organic Light-Emitting Diodes", Chemistry of materials, vol. 16, no. 23, 15 October 2004 (2004-10-15), pages 4556-4573, XP055032910, ISSN: 0897-4756, DOI: 10.1021/cm049473l
- X. H. Yang ET AL: "Supplementary Information for Blue polymer electrophosphorescent devices with different electron-transporting oxadiazoles", Applied Physics Letters, 13 January 2006 (2006-01-13), pages 021107-1, XP055455260,

## Description

### BACKGROUND OF THE INVENTION

The invention relates to an organic light emitting device and a method for manufacturing the same.

Optoelectronic devices, which may be classified as either organic or inorganic, are becoming increasingly desirable due to the improved properties. Examples of organic optoelectronic devices include organic light emitting devices (OLEDs), organic photovoltaic devices, organic photodetectors, organic transistors, etc.

OLEDs have great potential in the display and lighting industry due to their increased brightness, faster response time, lighter weight, and lower power consumption than currently existing technologies such as incandescence or compact fluorescence devices. To achieve high efficiency, an OLED is typically formed with a multilayer structure, which is to provide desirable confinement of charge carriers and/or excitons, on a substrate such as a glass substrate or a transparent plastic substrate. The multilayer structure includes a light-emitting layer of an organic electroluminescent (EL) material and optional adjacent organic semiconductor layers that are sandwiched between a cathode and an anode. The organic EL material may be a polymer organic semiconductor material or a low molecule organic semiconductor material. The organic semiconductor layers are specifically chosen based on the ability to assist in injecting and transporting holes, for example, as a hole injecting layer and a hole transporting layer, and the ability to assist in injecting and transporting electrons, for example, as an electron injecting layer and an electron transporting layer. When a forward bias is applied across the anode and the cathode, electrons (negative charges) and holes (positive charges) injected from the cathode and the anode recombine as excitons in the organic EL layer, and the excitons radiatively decay to generate light.

OLEDs are traditionally fabricated in a batch process by sequentially depositing organic semiconductor layers followed by a cathode onto an anode bearing substrate such as a glass or a transparent plastic substrate. In general, the process for depositing a polymer organic semiconductor layer is different from that for depositing a low molecule organic semiconductor layer. The former involves a solution-based process, i.e., a wet-coating process, in which the material may be applied from its solution by means of spin-coating, spray coating, dip coating, screen printing, ink-jet printing or roller coating etc, for example, while the latter involves a dry-coating process such as thermal evaporation under high or ultrahigh vacuum.

In general, the application of an electron transporting material (ETM) (or more preferably, a material having dual functions, i.e., transporting electrons and blocking holes) atop the light-emitting layer can be easily achieved in low molecule based OLEDs where the one or more organic layers are deposited via, for example, thermal evaporation. In contrast, it is challenging to achieve such multilayer structures in wet-coated polymer based OLEDs where application of each layer is carried out via a solution-based process such as spin-coating, ink-jet printing, etc, because the solvent used for the subsequent layer such as an electron transporting layer may attack the pre-deposited underlying layer such as the light-emitting layer and render the characteristic of the finished OLED low in quality and productivity.

Another type of organic optoelectronic device is an organic photovoltaic device. An organic photovoltaic device typically comprises a pair of electrodes and a light-absorbing photovoltaic material disposed therebetween. When the photovoltaic material is irradiated with light, electrons that have been confined to an atom in the photovoltaic material are released by light energy to move freely. Thus, free electrons and holes are generated. The free electrons and holes are efficiently separated so that electric energy is continuously extracted. An organic photovoltaic device typically has a similar material composition and/or structure as an OLED yet performs an opposite energy conversion process. Also similarly, in manufacturing an organic optoelectronic device, the same problem general arises.

It may be desirable to have an organic optoelectronic device and a method of manufacturing the same, which differ from those commercially available.

US 2005/147842 A1 concerns an organic electroluminescence device comprising a plurality of the layers of polymeric materials soluble in an organic solvent.

Tanaka D, et al entitled: "High Luminous Efficiency Blue Organic Light-Emitting Devices Using High Triplet Excited Energy Materials", JAPANESE JPURNAL OF APPLIED PHYSICS, vol. 46, no. 5, 26 January 2007, pages L117-L119, XP002523000, discloses that a highly efficient blue OLEDs have been fabricated by using a phosphorescent emitter, iridium(III) bis[(4,6-di-fluorophenyl)-pyridinate-N,C2']picolinate, and high triplet energy materials as the host and the carrier transport materials. A high power efficiency of 39 lm/W and external quantum efficiency of 21% were obtained at 100 cd/m2.

Kido, J. entitled: "Recent Progress in Organic Light-Emitting Devices", IEEE POLYTRONIC 2007 CONFERENCE, 2007, page 18-19, XP002523001, discloses a variety of wide-energy-gap charge transport materials that have been prepared and used for phosphorescent OLEDs. For instance, 1,3,5-tris[3,5-bis(3-pyridinyl)-phenyl]benzene (TPPB) was synthesized and used as an electron transport layer. A high power efficiency of 37 lm/W was achieved for blue OLED using iridium(III)-bis[2-(4,6-difluorophenyl)pyridinate-N, C2']picolinate (FIrpic) as an emitter. Long lifetime has been achieved by using the tandem structure, so called multiphoton emission (MPE) structure. A long lifetime such as over 100,000 hrs at 1000 cd/m2 has been achieved for an amber OLED. A white OLED exhibited over 30,000 hrs lifetime with the initial luminance of 5000 cd/m2, which promises that OLEDs can be used not only for displays, but also for general lighting.

Abhishek P. Kultarni et al, entitled: "Electron Transport Materials for Organic Light-Emitting Diodes", Chemistry of materials, vol. 16, no. 23, 15 October 2004, pages 4556-4573, XP055032910, ISSN: 0897-4756, DOI: 10.1021/cm0494731 presents a comprehensive review of the literature on electron transport materials (ETMs) used in OLEDs. More than 15 diverse classes of ETMs, both small-molecule and polymer-based, are discussed. Important material properties that influence OLED performance, such as electronic structure, electron mobility, and thermal stability, are highlighted.

JP 2006 019156 A discloses a manufacturing method of an electroluminescent element, in which an electroluminescent layer comprising a plurality of functional layers laminated by the printing method is held between electrodes facing each other, has a process to laminate functional ink in a support body, a process to make a functional thin film by vaporizing the volatile part of the functional ink, a process to make a first functional layer by transferring the functional thin film to a body to be transferred which contains one of the facing electrodes, and a process to laminate a second functional layer on the first functional layer by repeating these processes.

X. H. Yang, et al, in "Blue polymer electrophosphorescent devices with different electron-transporting oxadiazoles" and "Information for Blue polymer electrophosphorescent devices with different electron-transporting oxadiazoles", Applied Physics Letters 88, 13 January 2006, pages 021107-1, XP055455260, report that the performances of blue polymer electrophosphorescent devices are crucially depending on the choice of the electron transporting material incorporated into the emissive layer. Devices with 1,3-bis[(4-tert-butylphenyl)-1,3,4-oxidiazolyl]phenylene (OXD-7) doped at ∼40wt% into a poly(vinylcarbazole) matrix exhibited significantly higher efficiencies than those with 2-(4-biphenylyl)-5-(4-tert-butylphenyl)-1,3,4-oxadiazole (PBD), yielding maximum luminous and power efficiency values of 18.2 Cd / A and 8.8 lm / W, respectively. Time resolved photoluminescence measurements revealed a long lifetime phosphorescence component in layers with PBD, which we assign to significant triplet harvesting by this electron-transporting component.

### BRIEF DESCRIPTION OF THE INVENTION

It is an object of the present invention to provide an organic light emitting device, and a method for manufacturing said organic light emitting device.

The object is achieved by the features of the respective independent claims. Further embodiments and developments are defined in the dependent claims.

### BRIEF DESCRIPTION OF THE DRAWINGS

The present invention will become more fully understood from the detailed description given hereinafter and the accompanying drawings which are given by way of illustration only, and thus are not limitative of the present invention and wherein:
FIG. 1 shows a schematic view of an OLED according to a first embodiment of the present invention.
FIG. 2 shows a schematic view of an OLED according to a second embodiment of the present invention.
FIG. 3 shows a schematic view of an OLED according to a third embodiment of the present invention.
FIG. 4 shows the current-voltage characteristics of devices prepared in example 1 as a function of TYPMB loadings.
FIG. 5 shows the electroluminescence spectrum of an OLED prepared in example 2.
FIG. 6 shows the current density and brightness of the OLED prepared in example 2 as a function of the bias voltage.
FIG. 7 shows the external quantum efficiency of the OLED prepared example 2 as a function of the current density.
FIG. 8 shows the current efficiency of the OLED prepared example 2 as a function of the current density.

### DETAILED DESCRIPTION OF THE INVENTION

The present invention will now be described in detail for specific embodiments of the invention. These embodiments are intended only as illustrative examples and the invention is not to be limited thereto. It should be understood by those skilled in the relevant art that the figures accompanying this disclosure are also illustrative and not drawn to scale.

As used herein, "light" means generally electromagnetic radiation having wavelengths in the range from ultraviolet ("UV") to mid-infrared ("mid-IR") or, in other words, wavelengths in the range from about 300 nm to about 10 micrometers.

It will be understood that when an element or a layer is referred to as being "on" or "connected to" another element or layer, it can be directly on or connected to the other element or layer, or an intervening element or layer may be present therebetween. In contrast, when an element is referred to as being "directly on" or "directly connected to" another element or layer, there are no intervening elements or layers present therebetween. Also, as used herein, the indefinite article "a" or "an" preceding an article means "at least one" of the articles.

As used herein, the term "organic" includes polymer materials as well as low molecule organic materials that may be used to fabricate an organic optoelectronic device. Polymer refers to the organic material having the molecular weight of 10,000-100,000 and a plurality of repeating units. Low molecule or low molecular weight material may actually be quite large in molecular weight and generally refers to the organic material having the molecular weight of 500-2,000. Also, low molecules may include repeating units in some circumstances. For example, using a long chain alkyl group as a substituent does not remove a molecule from the "low molecule" class.

Hereinafter, as a specific example of the optoelectronic device according to an embodiment of the present invention, an organic light emitting device (OLED) and method for making the same is described in detail, and also as a specific example of organic electron material, a light-emitting material is described.

In general, the embodiments of the present invention provide a multilayer organic light-emitting device (OLED), that comprises an electron transporting layer. The electron transporting layer can be formed by a solution-based process when manufacturing the multilayer OLED. In general, the electron transporting material (ETM) of the electron transporting layer has the function of transporting electrons and also has the function of blocking excess holes, i.e., dual functions. Therefore, the electron transporting material sometimes is also referred to electron transporting and hole blocking material (ET-HBM), and to some degree, the terms ETM and ET-HBM are interchangeable in this disclosure.

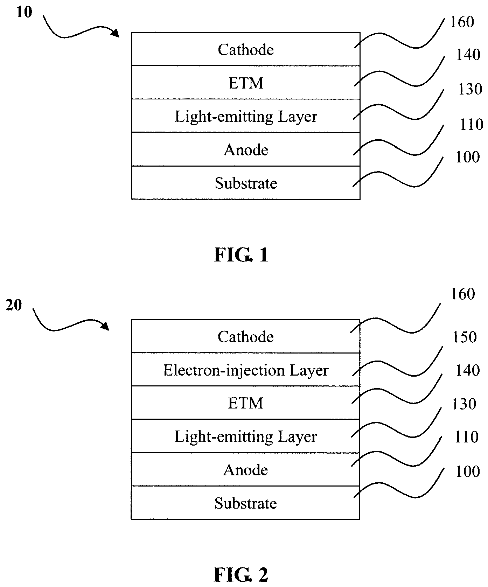

FIG. 1 schematically shows a multilayer OLED 10 according to a first embodiment of the present invention. This multilayer OLED 10 comprises a substrate 100 and an anode 110, a light-emitting layer 130, an electron transporting layer 140, and a cathode 160 that are stacked in this order on the substrate 100. When a forward bias is applied across the anode 110 and the cathode 160 of the OLED 10, holes (positive charges) and electrons (negative charges) are injected from the anode 110 and the cathode 160, respectively, into the light-emitting layer 130, where the holes and electrons recombine to form excited molecules ("excitons") at high energy, which subsequently drop to a lower energy level, concurrently emitting light, e.g., visual light. The high-energy excitons are in either singlet excited state or triplet excited state. The light generation process is generally understood as electroluminescence that may be further divided up into electrofluorescence or electrophosphorescence depending on whether the excitons are in singlet or triplet excited state.

The respective components of the OLED 10 according to the first embodiment of the present invention are described in detail in the following.

The substrate 100 may be a single piece or a structure comprising a plurality of adjacent pieces of different materials and has a refractive index in the range from about 1.05 to about 2.5, preferably from about 1.1 to 1.55. Preferably, the substrate 100 is made of a substantially transparent glass or polymeric material. Examples of suitable polymeric materials for the substrate comprise PET, polyacrylates, polycarbonates, polyesters, polysulfones, polyetherimides, silicone, epoxy resins, or silicone-functionalized epoxy resins.

The anode 110 of the OLED 10 comprises a material having a high work function, e.g., greater than about 4.4 eV, for example from about 5 eV to about 7 eV. Indium tin oxide (ITO) is typically used for this purpose. ITO is substantially transparent to light transmission and allows light emitted from the light-emitting layer 130 easily to escape without being seriously attenuated. Other materials suitable for use as the anode 110 are tin oxide, indium oxide, zinc oxide, indium zinc oxide, zinc indium tin oxide, antimony oxide, or any mixture thereof. Still other suitable materials for anode 110 include carbon nanotubes, or metals such as silver or gold. The anode 110 may be deposited on the underlying substrate by physical vapor deposition, chemical vapor deposition, or sputtering. The thickness of an anode 110 comprising such an electrically conducting oxide can be in the range from about 10 nm to about 500 nm, preferably from about 10 nm to about 200 nm, and more preferably from about 50 nm to about 200 nm.

The light-emitting layer 130 serves as a medium in which both holes and electrons recombine to form excitons that radiatively decay to emit light. Materials used in the light-emitting layer 130 may be polymeric materials as well as low molecule organic materials and are chosen to produce light in a desired wavelength range. The thickness of the layer 130 is preferably kept in the range from about 10nm to about 300 nm. The organic light-emitting material may be an organic material, such as a polymer, a copolymer, a mixture of polymers, or lower molecular-weight organic molecules having unsaturated bonds. Such materials possess a delocalized pi-electron system, which gives the polymer chains or organic molecules the ability to support positive and negative charge carriers with high mobility. Suitable light-emitting polymers comprise poly(N-vinylcarbazole) ("PVK", emitting violet-to-blue light in the wavelengths of about 380∼500 nm) and its derivatives; polyfluorene and its derivatives such as poly(alkylfluorene), for example poly(9,9-dihexylfluorene) (about 410∼550nm), poly(dioctylfluorene) (wavelength at peak EL emission of about 436 nm) or poly{9,9-bis(3,6-dioxaheptyl)-fluorene-2,7-diyl} (about 400∼550 nm); poly(praraphenylene) ("PPP") and its derivatives such as poly(2-decyloxy-1,4-phenylene) (about 400∼550 nm) or poly(2,5-diheptyl-1,4-phenylene); poly(p-phenylene vinylene) ("PPV") and its derivatives such as dialkoxy-substituted PPV and cyano-substituted PPV; polythiophene and its derivatives such as poly(3-alkylthiophene), poly(4,4'-dialkyl-2,2'-biothiophene), poly(2,5-thienylene vinylene); poly(pyridine vinylene) and its derivatives; polyquinoxaline and its derivatives; and poly quinoline and its derivatives. Mixtures of these polymers or copolymers based on one or more of these polymers and others may be used to tune the color of emitted light.

Another class of suitable light-emitting polymers is the polysilanes. Polysilanes are linear silicon-backbone polymers substituted with a variety of alkyl and/or aryl side groups. These materials are quasi one-dimensional materials with delocalized sigma-conjugated electrons along polymer backbone chains. Examples of polysilanes comprise poly(di-n-butylsilane), poly(di-n-pentylsilane), poly(di-n-hexylsilane), poly(methylphenylsilane), and poly{bis(p-butylphenyl)silane}, which are, for example, disclosed in H. Suzuki et al., "Near-Ultraviolet Electroluminescence From Polysilanes, " Thin Solid Films, Vol. 331, 64 70 (1998). These polysilanes emit light having wavelengths in the range from about 320 nm to about 420 nm.

Organic materials having molecular weight less than, for example, about 5000 that are made of a large number of aromatic units are also applicable. An example of such materials is 1,3,5-tris {n-(4-diphenylaminophenyl) phenylamino}benzene,

which emits light in the wavelength range of about 380∼500 nm. The organic light-emitting layer also may be prepared from lower molecular-weight organic molecules, such as phenylanthracene, tetraarylethene, coumarin, rubrene, tetraphenylbutadiene, anthracene, perylene, coronene, or their derivatives. These materials generally emit light having maximum wavelength of about 520 nm. Still other suitable materials are the low molecular-weight metal organic complexes such as aluminum-, gallium-, and indium-acetylacetonate, which emit light in the wavelength range of about 415∼457 nm, aluminum-(picolymethylketone)-bis {2,6-di(t-butyl)phenoxide}or scandium-(4-methoxy-picolylmethylketone)-bis (acetylacetonate), which emits in the range of about 420∼433 nm. For white light application, the preferred organic light-emitting materials are those emit light in the blue-green wavelengths.

Other suitable organic light-emitting materials that emit in the visible wavelength range are organo-metallic complexes of 8-hydroxyquinoline, such as tris(8-quinolinolato)aluminum and its derivatives. Other non-limiting examples of organic light-emitting materials are, for example, disclosed in U. Mitschke and P. Bauerle, "The Electroluminescence of Organic Materials," J. Mater. Chem., Vol. 10, pp. 1471 1507 (2000).

An organic light-emitting material is deposited on the underlying layer (e.g., an anode or a cathode) by physical or chemical vapor deposition, spin coating, dip coating, spraying, ink-jet printing, gravure coating, flexo-coating, screen printing, or casting, followed by polymerization, if necessary, or curing of the material.

The cathode 160 is made of a material having a low work function, e.g., less than about 4 eV. Low-work function materials suitable for use as a cathode are K, Li, Na, Mg, Ca, Sr, Ba, Al, Ag, Au, In, Sn, Zn, Zr, Sc, Y, elements of the lanthanide series, alloys thereof, or mixtures thereof. Suitable alloy materials for the manufacture of cathode 160 are Ag-Mg, Al-Li, In-Mg, Al-Ca alloys, and the like. Layered non-alloy structures are also possible, such as a thin layer of a metal such as Ca (thickness from about 1 to about 10 nm) or a non-metal such as LiF, KF, or NaF, covered by a thicker layer of some other metal, such as aluminum or silver. Cathode 150 may be deposited on the underlying element by physical vapor deposition, chemical vapor deposition, or sputtering. Preferably, cathode 160 is substantially transparent. In some circumstances, it may be desirable to provide a substantially transparent cathode that is made of a material selected from the group consisting of ITO, tin oxide, indium oxide, zinc oxide, indium zinc oxide, zinc indium tin oxide, antimony oxide, and mixtures thereof. Materials such as carbon nanotubes may also be used as cathode material. A thin, substantially transparent layer of a metal is also suitable, for example, a layer having a thickness less than about 50 nm, preferably less than about 20 nm.

In the first embodiment of the present invention, the electron transporting layer 140 is provided on the light-emitting layer 130 and is used for transporting the electrons injected from the cathode 160 into the light-emitting layer 130, keeping recombination zone of the injected holes and injected electrons away from the cathode 160 to prevent quenching by the cathode 160, and as well preventing or blocking the holes injected from the anode 110 from traversing through the light-emitting layer 130 without recombination, thus improving the light emission efficiency. In this regard, this electron transporting layer 140 sometimes is also referred to as an electron transporting and hole blocking layer.

Generally, the material selection of the electron transporting layer (ETL) in an OLED depends on its bandgaps (singlet and/or triplet), energy levels (highest occupied molecular orbital (HOMO) and/or lowest unoccupied molecular orbital (LUMO)), solubility, etc. In particular, a suitable ETL should have a LUMO level that meets the following two requirements: 1) the LUMO of the ETL should be compatible with the energy level of the cathode material to achieve efficient electron injection from the cathode into the ETL, and 2) the LUMO of the ETL should be compatible with the LUMO of the light-emitting layer to ensure efficient electron transport from the ETL into the light-emitting layer. Generally, light-emitting materials such as polyfluorene based and or polyphenylvinylene based fluorescent light-emitting polymers and phosphorescent emissive organometallic complexes have a LUMO in the range of about 2.0eV to about 3.0eV. Also, cathode materials usually comprise alkali metals and alkaline metals having a work function in the range of about 1.8eV (Cesium) and about 2.9eV (Lithium). Thus the LUMO of a suitable ETL is preferred to be in the range of about 1.8eV to about 3.0eV, and more preferred to be in the range of about 2.0eV to about 2.5eV In addition, a suitable ETL should possess a HOMO level no less than the HOMO of the light-emitting layer to ensure efficient hole blocking effect. Further generally, the emissive materials typically have a HOMO in the range of 4.5eV to 6.0eV Thus the HOMO of a suitable ETL is preferably deeper than 6.0eV. For instance, if a FIrpic-containing material is used in the light-emitting layer in the OLED, a material candidate of the electron transporting layer may possess at least the following properties: 1) a triplet gap greater than that (2.7eV) of the FIrpic to prevent emission quenching, 2) an HOMO level deeper than that (5.5eV) of the FIrpic to provide hole-blocking, 3) a LUMO level shallower than that (2.5eV) of FIrpic to achieve efficient electron injection from the ETL into the FIrpic-containing emissive layer, and 4) solubility in at least one solvent that will not dissolve the FIrpic-containing layer.

Several techniques have been commonly used to determine LUMO and HOMO levels of organic materials. One well-accepted and fairly reliable technique for measuring LUMO as well as HOMO is cyclic-voltammetry (CV), an electrochemical measurement as described by J. Hwang, E.G. Kim, J. Liu, J.L. Bredas, A. Duggal and A. Kahn, "Photoelectron spectroscopic study of the electronic band structure of polyfluorene and fluorene-arylamine copolymers at interfaces", J. Phys. Chem., C, 111, 1378-1384 (2007). Another commonly used technique is a two-step technique 1) to separately measure the HOMO level by CV and the optical bandgap by UV-vis absorption and 2) to mathematically determine the LUMO by subtracting the value of the optical bandgap from the HOMO value.

Here the electron transporting layer 140 of the first embodiment of the present invention comprises a blend of a low molecular weight electron transporting material having a LUMO between about 1.8eV to about 3.0eV and a film-forming polymer having a LUMO greater than that of the low molecular weight electron transporting material. This blend can be solution-processed to form the electron transporting layer in the multilayer OLED 10. The low molecular weight electron transporting material provides the desired electrical property, while the film-forming polymer enables to form a desired thin film, i.e., has the film-forming ability. The general guideline for the electron transporting layer composition selection includes: (1) both the low molecular weight material and film-forming polymer should have high purity since impurities present in the electron transporting layer could negatively affect the whole device performance; and (2) both the low molecular weight material and film-forming polymer should be soluble in a solvent or a mixture of solvents that is antisolvent for the light-emitting material, thus enabling direct coating of the electron transporting layer atop of a pre-deposited layer without damaging this layer, and such pre-deposited layer may be a light-emitting layer in the first embodiment as shown in FIG. 1 or an electron injection layer in the case that the cathode is first formed on a substrate and the electron injection layer is then formed on the cathode.

Low molecular weight organic materials comprising the following function groups and their derivatives are usually considered as electron transport materials: 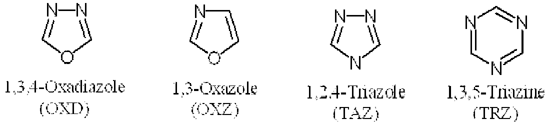 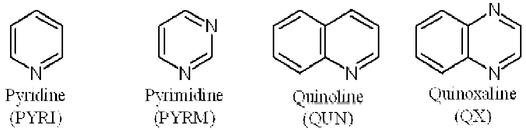 The low molecular weight electron transporting material of the present invention used in the electron transporting composition in OLED 10 comprises at least one pyridinyl group to provide the function of electron transporting and to some extend, the function of hole blocking.

Examples of the low molecular weight electron transporting materials comprising at least one pyridinyl group are phenyl pyridine based materials, and these materials usually have: (1) LUMO between 2.0 and 3.0eV (i.e., good electron injection and transport properties); (2) HOMO > 6.0eV (i.e., being desirable for hole blocking); and (3) wide solubility window (soluble in a wide range of solvents including alcohols, acetates, etc, which are usually anti-solvents for polymers). In addition, these materials have triplet gap > 2.6eV, thus is suitable for blue phosphorescent OLEDs. For example, particular candidates for the low molecular weight pyridine based materials comprise:

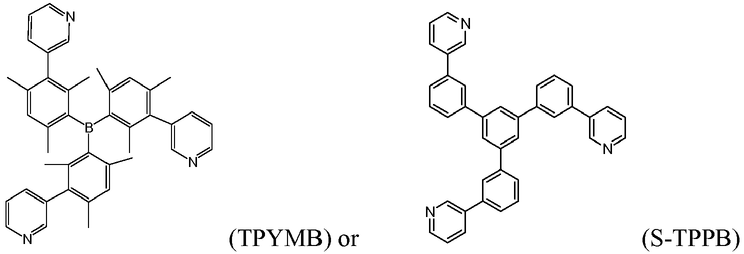

The film-forming polymer is used in the electron transporting layer composition to provide a desired thin film in OLED 10 and has a film forming function. Furthermore, the film-forming polymer also can act to block the holes traversing the light-emitting layer 130. The film-forming polymer in the present invention is selected from wide bandgap materials (that have a bandgap >= 3.3eV or equivalently, an onset of absorption <=370nm), that is the film-forming polymer is poly(2-vinylpyridine), poly(4-vinylpyridine), polystyrene, or poly(vinyl phenyl pyridine). Also, the film-forming polymer has a LUMO shallower (or less) than that of the low molecular weight electron transporting material used together in the electron transporting layer composition. Further, the film-forming polymer should have a HOMO level deeper than that of the emissive layer. For example, the particular candidates for the film-forming polymer comprise: 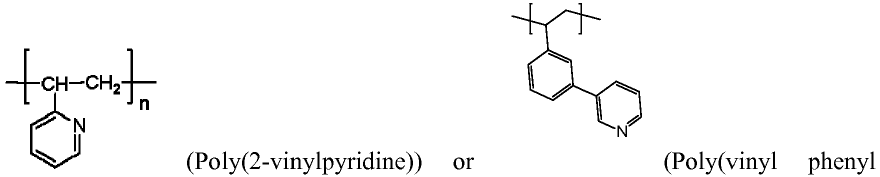 pyridine))

In addition, as mentioned above, the light-emitting layer 130 in the OLED 10 can be a fluorescent emitter, a phosphorescent emitter, or a combination of both. For a fluorescent emitter as the light emitting material, the electron transporting layer 140 should have a singlet bandgap greater than that of the fluorescent emitter. For a phosphorescent emitter as the light emitting material, the electron transporting layer 140 should have a triplet gap greater than that of the phosphorescent emitter. The singlet bandgap can be readily measured with techniques such as UV-Visible absorption spectroscopy and photoluminescence spectroscopy, while the triplet bandgap can be measured with transient photoluminescence spectroscopy under low temperatures such as 77K. A rule-of-thumb guideline for material selection of the electron transporting layer composition is to have a film-forming polymer with a singlet (or triplet) bandgap no less than that of the low molecular weight electron transporting material employed.

An example of the electron transporting layer composition may comprise one low molecular weight pyridine based material and polystyrene based film-forming polymer, and this composition is used for forming the electron transporting layer 140 in the OLED 10. The low molecular weight pyridine based material acts as the electron transporting material, while both the low molecular weight pyridine based material and the poly(2-vinylpyridine) based film-forming polymer provide the desired hole blocking property.

The electron transporting layer 140 can be formed atop the light-emitting layer 130 in the OLED 10 in the first embodiment of the present invention as follows. First, the composition of electron transporting layer can be obtained by blending the film-forming polymer and the low molecular weight electron transporting material, with an appropriate weight loading, in a solvent such as xylene and toluene, so as to possess both the desirable electron transporting and hole blocking function and the proper film forming property. The rule-of-thumb guideline for solvent selection is to choose a solvent that dissolves the low molecular weight electron transporting layer and the film-forming polymer but is an antisolvent for the light-emitting materials used in the OLEDs. Solvents suitable for this purpose may include xylene, toluene, ketones (such as butanone, hexanone, and cyclohexanone etc), alcohols (such as butanol,) and acetates (such as butyl acetate and ethyl acetate). The amount of the low molecular weight electron transporting material in the electron transporting layer ranges from 50% to 90% by weight of the blend. The application method of the ETM composition may include but not be limited to a solution-based process, such as spin-coating, spray coating, dip coating, screen printing, ink-jet printing, roller coating or casting. With one of these solution-based processes, the electron transporting layer 140 can be prepared without use of any dry-coating process such as thermal evaporation under high or ultrahigh vacuum, and therefore the efficiency of the OLED fabrication process can be greatly improved, and thus the related costs can be reduced and productivity are improved.

The OLED 10 of the first embodiment of the present invention can be manufactured as follows. First, there is provided, for example, a pre-cleaned glass substrate as the substrate 100, and on the substrate 100 is formed an ITO layer as the anode 110, for example, by depositing. Next, a PVK layer is formed as the light-emitting layer 130 on the anode 110 by coating. Then, on the top of the light-emitting layer 130 is formed the electron transporting layer 140 by a solution-based process with a composition prepared in accordance with the above mentioned method. Subsequently, an Al layer as the cathode 160 is formed on the electron transporting layer 140 by depositing, thus completing the preparation of the stacked layers. Finally, such structure of the stacked layers is delivered to be sealed and packaged as a finished device.

FIG. 2 shows a schematic view of an OLED 20 according to a second embodiment of the present invention. The OLED 20 has the same multiplayer structure as that of the OLED 10 except that an electron injection layer 150 is further interposed between the electron transporting layer 140 and the cathode 160 for improving the function of injecting electron from the cathode 160. The same functional layers in the OLED 20 as those of the OLED 10 shown in FIG. 1 have been indicated with the same reference numbers, and for simplicity, the description thereof is omitted.

The electron injection layer 150 is interposed between the cathode 160 and the electron transporting layer 140, and materials suitable for this electron injection layer 150 comprise metal organic complexes of 8-hydroxyquinoline, such as tris(8-quinolinolato)aluminum; stilbene derivatives; anthracene derivatives; perylene derivatives; metal thioxinoid compounds; oxadiazole derivatives and metal chelates; pyridine derivatives; pyrimidine derivatives; quinoline derivatives; quinoxaline derivatives; diphenylquinone derivatives; nitro-substituted fluorene derivatives; and triazines. The materials can be applied by the methods such as spray coating, dip coating, spin coating, screen printing, physical or chemical vapor deposition, etc.

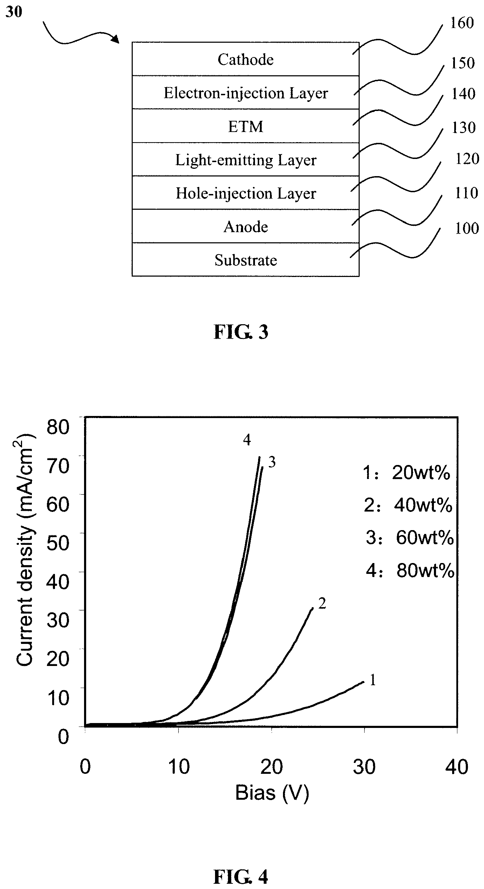

FIG. 3 shows a schematic view of an OLED 30 according to a third embodiment of the present invention. The OLED 30 has the same multiplayer structure as that of the OLED 20 except that a hole injection layer 120 is interposed between the anode 110 and the light-emitting layer 130. The same functional layers in the OLED 30 as those of the OLED 20 shown in FIG. 1 have been indicated with the same reference numbers, and for simplicity, the description thereof is omitted.

The hole injection layer 120 is interposed between the anode 110 and the light-emitting layer 130 to facilitate and achieve efficient hole injection from the anode 110 to the lighting emitting layer 130 to maximize the overall device performance. Suitable materials for this hole injection layer p-doped organic semiconductors such as PEDOT:SS and/or TCNQ.

In addition, in the third embodiment as shown in FIG. 3, a hole transporting layer may be formed and interposed between the hole injection layer 120 and the light-emitting layer 130, and this hole transporting layer serves to improve the transport of the holes, which are injected from the hole injection layer 120, into the light-emitting layer 130. Materials suitable for the hole transporting layer are triaryldiamine, tetraphenyldiamine, aromatic tertiary amines, hydrazone derivatives, carbazole derivatives, triazole derivatives, imidazole derivatives, oxadiazole derivatives having an amino group, and polythiophenes. The hole transporting layer may be applied during the manufacture by the methods such as spray coating, dip coating, spin coating, screen printing, physical or chemical vapor deposition, etc. This hole transporting layer generally further has the function of blocking the transportation of electrons that traverse the light-emitting layer, so that holes and electrons are optimally confined and recombined in the light-emitting layer 130. Also, the hole transporting layer can be referred to as a hole transporting and electron blocking layer, and the terms "hole transporting layer" and "hole transporting and electron blocking layer" are interchangeable in this disclosure.

Moreover, in another embodiment of the present invention, there can be formed a separate electron blocking layer between the hole transporting layer and the light-emitting layer. For example, suitable materials for this separate electron blocking layer may comprise N,N'-diphenyl-N,N'-(3-methylphenyl) -1,1'-biphenyl-4,4'-diamine or poly(3-octyl-4-methylthiophene).

Although in the above mentioned embodiments of the present invention, there is provided an electron transporting layer, there may be formed another separate hole blocking layer between the electron transporting layer and the light-emitting layer for enhancing the function of hole blocking. Suitable materials for this separate hole blocking layer comprise the following exemplary ones: poly(N-vinyl carbazole), bathocurpoine ("BCP"), bis(2-methyl-8-quinolinato)triphenylsilanolate aluminum (III), bis(2-methyl-8-quinolinato)4-phenolate aluminum (III), or bis(2-methyl-8-quinolinato)4-phenylphenolate aluminum (III).

In another embodiment not forming part of the present invention, there is provided a photovoltaic device comprising a light absorbing layer and an electron transporting layer, which are interposed between an anode and a cathode, and the electron transporting layer comprises a blend of a low molecular weight electron transporting material having a LUMO between about 1.8eV to about 3.0eV and a film-forming polymer having a LUMO greater than that of the low molecular weight electron transporting material, the electron transporting layer being formed on the light absorbing layer. This electron transporting layer can also be formed with the above mentioned materials by a solution-based process.

In addition, the above embodiments have the anode layer formed on the substrate and other functional layers are stacked sequentially on the anode layer. However, such sequence is not limitative and can be reversed. The OLED may have the cathode first formed on a substrate and other functional layers are stacked sequentially on the cathode layer, or the functional layer stack of the OLED could be interposed between the cathode and anode that are formed an upper and a lower substrates, respectively.

### EXAMPLES OF THE INVENTION

### Example 1: Electron-only devices comprising mixtures of polystyrene and TPYMB (Only solutions 3 and 4 having the TPYMB loadings of 60% and 80% are examples according to the present invention)

Pre-cleaned glass was used as the substrate. First, a 100-nanometer layer of Al, as a bottom electrode, was first deposited atop the glass substrate using thermal evaporation. Then an approximately 75 nanometer thick layer of polystyrene (PS):TPYMB (with different TPYMB weight loadings) was deposited on the Al layer by spin-coating techniques, followed by baking at 80oC for 20 minutes in a glovebox filled with Argon. Then a bilayer of NaF/Al top electrode was deposited using thermal evaporation at a base vacuum of 2 X 10-6 torr onto the PS:TPYMB electron transporting layer. The prepared devices have the stacked layers of glass/PS:TPYMB/NaF/Al. Electrical properties of the devices were measured under a forward bias condition where the bottom Al electrode is positively biased and the top NaF/Al electrode negatively biased. These devices behave as unipolar electron-only devices due to the fact that in each device, the hole current injected from the bottom Al electrode into the PS:TPYMB layer is neglect relative to the electron current injected from the top NaF/Al because of the existence of a substantial energy barrier between the Fermi level (∼4.3eV) of the bottom Al electrode and the HOMO (highest occupied molecular orbit) of the TPYMB (∼6.0eV).

Four PS:TPYMB mixtures were prepared and evaluated in the prepared devices, as shown in the following Table 1. The mixtures were prepared by mixing appropriate amount of PS solutions in xylene and TPYMB solutions in xylene to achieve the target compositions.

**Table 1**

| Solution | TPYMB loading | PS | TPYMB |
|---|---|---|---|
| | | (mg) | (mg) |
| 1 | 20% | 30 | 6 |
| 2 | 40% | 30 | 12 |
| 3 | 60% | 30 | 18 |
| 4 | 80% | 30 | 24 |

Current-voltage characteristics of these devices as a function of TYPMB loadings are shown in FIG. 4. As one can see, the current of such devices is highly sensitive to the loading of TPYMB, the electro-active component, and becomes independent on the concentration when the loading reaches 60% and more. Also, this example shows that the composition of the electron transporting layer has good electron transporting function in a proper loading and good film-forming ability. Example 2: An OLED comprising a solution-based processed ETM composition

Glass pre-coated with indium tin oxide (ITO), pre-treated with UV-ozone was used as the substrate. As the hole injection layer, an approximately 60 nanometer thick layer of PEDOT:PSS (poly(3,4-ethylenedioxythiophene) doped with polystyrene sulfonic acid, purchased from H.C. Starck) was deposited on the ITO layer by spin-coating techniques, followed by baking at 180oC in air for an hour. Then a 30 nanometer layer of light-emitting phosphorescent polymer was deposited by spin-coating from a chlorobenzene solution of LEPP. The detailed information of LEPP can be found in U.S. patent applications 11/736023 and 11/736214. The structure formula of LEPP is shown as follows.

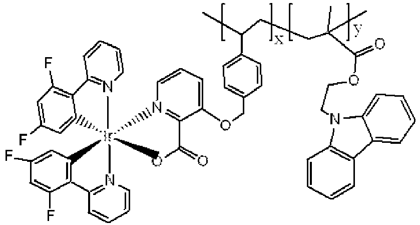

A mixture solution of the electron transporting layer composition of polystyrene (PS):TPYMB (40:60 wt%) was prepared by co-dissolving both materials in toluene, and the mixture solution was deposited as an electron transporting layer on the LEPP layer by spin coating techniques. Then a bilayer of NaF/Al cathode was deposited as the electron injection layer using thermal evaporation at a base vacuum of 2 X 10-6 torr onto the PS:TPYMB electron transporting layer. Finally, the device was sealed using an optical adhesive with a cover glass substrate. Thus, the prepared OLED has the stacked layers of glass/ITO/PEDOT:PSS/LEPP/NaF/Al.

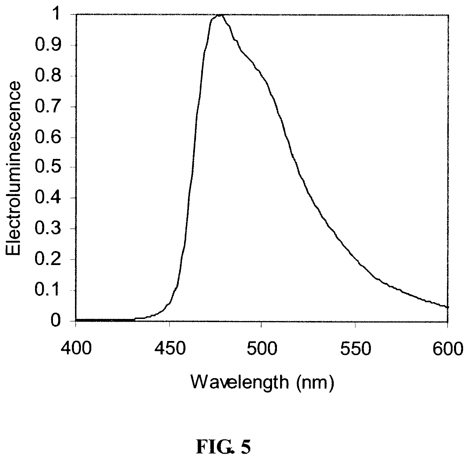

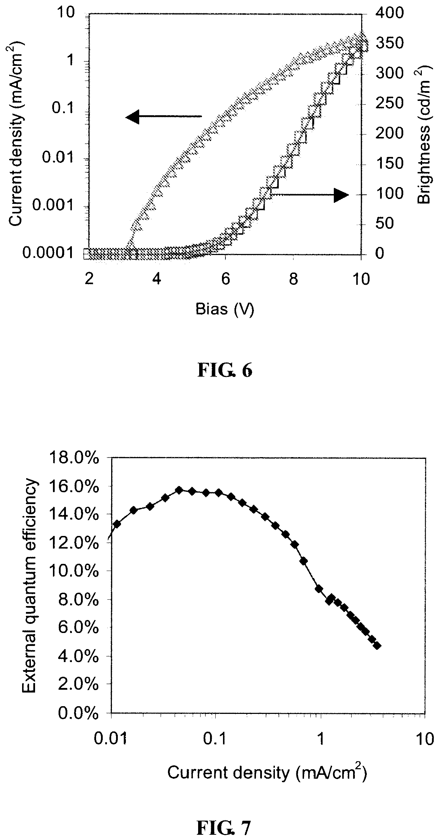

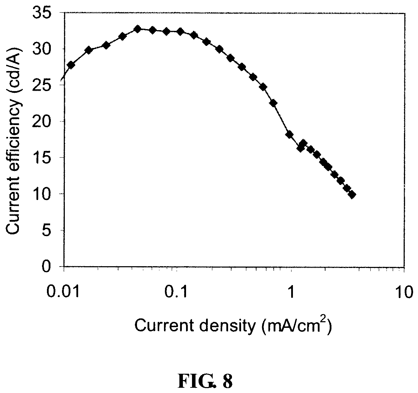

The efficiency and color spectrum of the device was measured. As shown in FIG. 5, the device exhibits a sky-blue electroluminescence spectrum characteristic to the photoluminescence of LEPP. FIG. 6 shows the current density and brightness of the OLED of example 2 as a function of the bias voltage. FIG. 7 and FIG.8 show the external quantum efficiency and current efficiency of the OLED of example 2 as a function of the current density, respectively. As one can see from FIG. 7 and FIG.8, the OLED of example 2 exhibits a maximum EQE of 15.7% and a current efficiency of 32.8 cd/A, which are much higher than the state-of-the-art performance ever achieved with a polymeric emissive layer, for example, those as mentioned in Shi-Jay Yeh et al, Advanced Materials, 2005, 17, No.3, p285-289 and Mathew K. Mathai et al, Applied Physics Letters 88, 243512 (2006).

## Claims

1. An organic light emitting device (10), comprising:
an anode (110), provided on a substrate (100), said substrate (100) having a refractive index in a range from 1.05 to 2.5;
an organic electron material layer formed on the anode (110),
an electron transporting and hole blocking layer (140) comprising a blend of a low molecular weight electron transporting material having a lowest unoccupied molecular orbital (LUMO) between 1.8eV to 3.0eV as obtained from cyclic voltammetry measurements, wherein the low molecular weight electron transporting material comprises at least one pyridinyl group and a film-forming polymer having a LUMO greater than that of the low molecular weight electron transporting material, wherein the film-forming polymer is poly(2-vinylpyridine), poly(4-vinylpyridine), polystyrene, or poly(vinyl phenyl pyridine), the electron transporting layer being formed on the organic electron material layer, and
a cathode (160) formed on the electron transporting and hole blocking layer (140);
wherein the organic electron material layer is a light-emitting layer (130), and
wherein the amount of the low molecular weight electron transporting material in the electron transporting layer (140) ranges from 50% to 90% by weight of the blend.

2. The organic light emitting device (10) according to claim 1, wherein the low molecular weight electron transporting material is

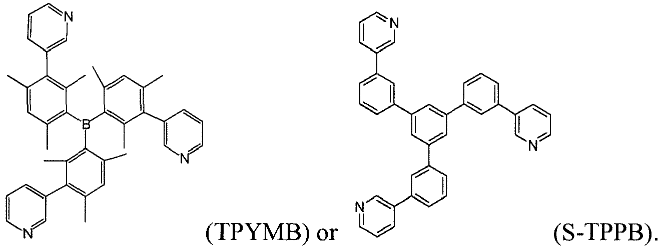

3. The organic light emitting device(10) according to claim 1, wherein the light-emitting layer (130) is made of a material selected from the group consisting of a fluorescent light emitting organic material, a phosphorescent light emitting organic material, and a mixture thereof.

4. The organic light emitting device (10) according to claim 1, further comprising, between the anode (110) and the light-emitting layer (130), a hole injection layer.

5. The organic light emitting device (10) according to claim 1, further comprising, between the anode (110) and the light-emitting layer (130), a hole transporting layer.

6. The organic light emitting device (10) according to claim 1, further comprising an electron injection layer that is interposed between the cathode (160) and the electron transporting layer (140).

7. A method for manufacturing an organic light emitting device (10), comprising the steps of:
providing a substrate (100) having a refractive index in a range from 1.05 to 2.5;
forming an anode (110) on the substrate (100);
forming an organic electron material layer as a light-emitting layer (130) on the anode (110);
forming an electron transporting and hole blocking layer (140) on the organic electron material layer by a solution-based process; and
forming a cathode layer (160)on the electron transporting and hole blocking layer (140),
wherein the electron transporting and hole blocking layer (140) comprises a blend of a low molecular weight electron transporting material having a lowest unoccupied molecular orbital(LUMO) between 1.8eV to 3.0eVas obtained from cyclic voltammetry measurements, wherein the low molecular weight electron transporting material comprises at least one pyridinyl group, and a film-forming polymer having a LUMO greater than that of the low molecular weight electron transporting material, wherein the film-forming polymer is poly(2-vinylpyridine), poly(4-vinylpyridine), polystyrene, or poly(vinyl phenyl pyridine); and
wherein the amount of the low molecular weight electron transporting material in the electron transporting layer (140) ranges from 50% to 90% by weight of the blend.

## Patentansprüche

1. Organische Lichtemittiervorrichtung (10) mit:
einer Anode (110) auf einem Substrat (100), wobei das Substrat (100) einen Brechungsindex in einem Bereich von 0,05 bis 2,5 aufweist;
einer organischen Elektrodenmaterialschicht, die auf der Anode (110) gebildet ist,
einer Elektronentransport- und Löchersperr-Schicht (140) mit einer Mischung eines Elektronentransportmaterials mit niedrigem Molekulargewicht, welches ein niedrigstes unbesetztes Molekularorbital (LUMO) zwischen 1,8eV bis 3,0eV, die mittels zyklischer Voltametriemessung erhalten wurden, aufweist, wobei das Elektronentransportmaterial mit geringem Molekulargewicht aufweist wenigstens eine Pyridinyl-Gruppe und ein dünnschichtbildendes Polymer mit einem LUMO größer als dem des Elektronentransportmaterials mit geringem Molekulargewicht, wobei das dünnschichtbildende Polymer Poly(2-Vinylpyridin), Poly(4-Vinylpyridin), Polystyren, oder Poly(vinylphenylpyridin) ist, wobei die Elektrodentransportschicht auf der organischen Elektronenmaterialschicht gebildet ist, und
einer Kathode (160), die auf der Elektronentransport- und Löchersperr-Schicht (140) gebildet ist;
wobei die organische Elektronenmaterialschicht eine lichtaussendende Schicht (130) ist, und
wobei die Menge des Elektronentransportmaterials mit geringem Molekulargewicht in der Elektronentransportschicht (140) im Bereich von 50% bis 90% des Gewichts der Mischung liegt.

2. Organische lichtaussendende Vorrichtung (10) gemäß Anspruch 1, wobei das Elektronentransportmaterial mit geringem Molekulargewicht ist

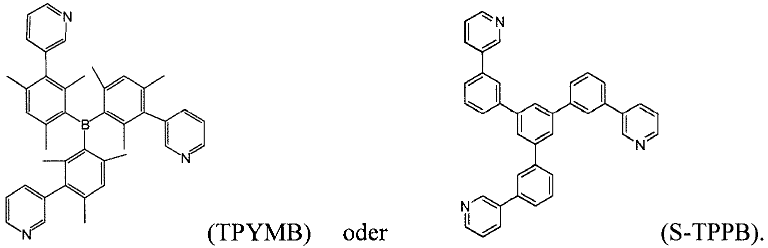

3. Organische lichtemittierende Vorrichtung (10) gemäß Anspruch 1, wobei die lichtemittierende Schicht (130) aus einem Material hergestellt ist, das ausgewählt ist aus der Gruppe, die besteht aus einem fluoreszenten lichtemittierenden organischen Material, einem phosphoreszierenden lichtemittierenden organischen Material und einer Mischung davon.

4. Organische lichtemittierende Vorrichtung (10) gemäß Anspruch 1 weiter mit zwischen der Anode (110) und der lichtemittierenden Schicht (130) einer Löcherinjektions-Schicht.

5. Organische lichtemittierende Vorrichtung (10) gemäß Anspruch 1 weiter mit zwischen der Anode (110) und der lichtemittierenden Schicht (130) einer Löchertransport-Schicht.

6. Organische lichtemittierende Vorrichtung (10) gemäß Anspruch 1 weiter mit einer Elektroneninjektions-Schicht, die zwischen der Kathode (160) und der ElektronentransportSchicht (140) angeordnet ist.

7. Verfahren zum Herstellen einer organischen lichtemittierenden Vorrichtung (10) aufweisend die Schritte:
Bereitstellen eines Substrats (100) mit einem Brechungsindex in einem Bereich von 1,05 bis 2,5;
Bilden einer Anode (110) auf dem Substrat (100);
Bilden einer organischen Elektronenmaterialschicht als eine lichtemittierende Schicht (130) auf der Anode (110);
Bilden einer Elektronentransport- und Löchersperr-Schicht (140) auf der organischen Elektronenmaterialschicht durch einen lösungsbasierten Vorgang;
Bilden einer Kathodenschicht (160) auf der Elektronentransport- und Löchersperr-Schicht (140),
wobei die Elektronentransport- und die Löchersperr-Schicht (140) aufweist eine Mischung aus einem Elektronentransportmaterial mit geringem Molekulargewicht, das ein niedrigstes unbesetztes Molekularorbital (LUMO) zwischen 1,8eV bis 3,0eV, die mittels zyklischer Voltametriemessung erhalten wurden, aufweist, wobei das Elektronentransportmaterial mit geringem Molekulargewicht aufweist wenigstens eine Pyridinyl-Gruppe und ein dünnschichtbildendes Polymer mit einem LUMO größer als dem des Elektronentransportmaterials mit geringem Molekulargewicht, wobei das dünnschichtbildende Polymer Poly(2-Vinylpyridin), Poly(4-Vinylpyridin), Polystyren, oder Poly(vinylphenylpyridin) ist; und
wobei die Menge des Elektronentransportmaterials mit geringem Molekulargewicht in der Elektronentransportschicht (140) in einem Bereich von 50% bis 90% des Mischungsgewichts liegt.

## Revendications

1. Dispositif électroluminescent organique (10), comprenant :
une anode (110) qui est prévue sur un substrat (100), ledit substrat (100) présentant un indice de réfraction qui s'inscrit à l'intérieur d'une plage qui va de 1,05 à 2,5 ;
une couche en un matériau électronique organique qui est formée sur l'anode (110) ;
une couche de transport d'électrons et de blocage de trous (140) qui comprend un mélange d'un matériau de transport d'électrons de poids moléculaire faible qui présente une orbitale moléculaire la plus basse non occupée (LUMO) qui s'inscrit à l'intérieur d'une plage qui va de 1,8 eV à 3,0 eV telle qu'obtenue à partir de mesures de voltamétrie cycliques, dans lequel le matériau de transport d'électrons de poids moléculaire faible comprend au moins un groupe pyridinyle, et d'un polymère de formation de film qui présente une LUMO qui est supérieure à celle du matériau de transport d'électrons de poids moléculaire faible, dans lequel le polymère de formation de film est le poly(2-vinylpyridine), le poly(4-vinylpyridine), le polystyrène ou le poly(vinylphénylpyridine), la couche de transport d'électrons étant formée sur la couche en un matériau électronique organique ; et
une cathode (160) qui est formée sur la couche de transport d'électrons et de blocage de trous (140) ; dans lequel :
la couche en un matériau électronique organique est une couche électroluminescente (130) ; et dans lequel :
la quantité du matériau de transport d'électrons de poids moléculaire faible dans la couche de transport d'électrons (140) s'inscrit à l'intérieur d'une plage qui va de 50 % à 90 % en poids du mélange.

2. Dispositif électroluminescent organique (10) selon la revendication 1, dans lequel le matériau de transport d'électrons de poids moléculaire faible est :

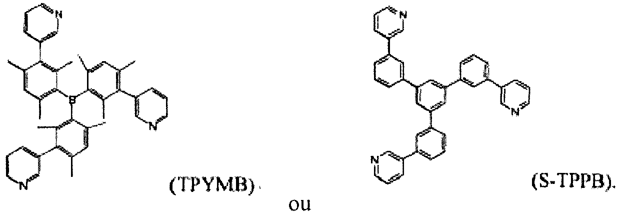

3. Dispositif électroluminescent organique (10) selon la revendication 1, dans lequel la couche électroluminescente (130) est réalisée à partir d'un matériau qui est sélectionné parmi le groupe qui est constitué par un matériau organique électroluminescent fluorescent, un matériau organique électroluminescent phosphorescent et un mélange de ceux-ci.

4. Dispositif électroluminescent organique (10) selon la revendication 1, comprenant en outre, entre l'anode (110) et la couche électroluminescente (130), une couche d'injection de trous.

5. Dispositif électroluminescent organique (10) selon la revendication 1, comprenant en outre, entre l'anode (110) et la couche électroluminescente (130), une couche de transport de trous.

6. Dispositif électroluminescent organique (10) selon la revendication 1, comprenant en outre une couche d'injection d'électrons qui est interposée entre la cathode (160) et la couche de transport d'électrons (140).

7. Procédé pour fabriquer un dispositif électroluminescent organique (10), comprenant les étapes constituées par :
la fourniture d'un substrat (100) qui présente un indice de réfraction qui s'inscrit à l'intérieur d'une plage qui va de 1,05 à 2,5 ;
la formation d'une anode (110) sur le substrat (100) ;
la formation d'une couche en un matériau électronique organique en tant que couche électroluminescente (130) sur l'anode (110) ;
la formation d'une couche de transport d'électrons et de blocage de trous (140) sur la couche en un matériau électronique organique au moyen d'un processus basé sur solution ; et
la formation d'une couche de cathode (160) sur la couche de transport d'électrons et de blocage de trous (140) ; dans lequel :
la couche de transport d'électrons et de blocage de trous (140) comprend un mélange d'un matériau de transport d'électrons de poids moléculaire faible qui présente une orbitale moléculaire la plus basse non occupée (LUMO) qui s'inscrit à l'intérieur d'une plage qui va de 1,8 eV à 3,0 eV telle qu'obtenue à partir de mesures de voltamétrie cycliques, dans lequel le matériau de transport d'électrons de poids moléculaire faible comprend au moins un groupe pyridinyle, et d'un polymère de formation de film qui présente une LUMO qui est supérieure à celle du matériau de transport d'électrons de poids moléculaire faible, dans lequel le polymère de formation de film est le poly(2-vinylpyridine), le poly(4-vinylpyridine), le polystyrène ou le poly(vinylphénylpyridine) ; et dans lequel :
la quantité du matériau de transport d'électrons de poids moléculaire faible dans la couche de transport d'électrons (140) s'inscrit à l'intérieur d'une plage qui va de 50 % à 90 % en poids du mélange.
